# FASCICULE DE BREVET EUROPEEN

(11) **EP 2 533 519 B1**
(45) Date de publication et mention de la délivrance du brevet: **19.03.2014**
(21) Numéro de dépôt: 12170651.9
(22) Date de dépôt: 04.06.2012
(51) Int. Cl.: H04N 5/33

(54) **Dispositif d'imagerie infrarouge à blindage intégré contre des rayonnements infrarouges parasites et procédé de fabrication du dispositif**
Infrarot-Abbildungsvorrichtung mit integrierter Abschirmung gegen Infrarot-Störstrahlung und Verfahren zum Herstellen der Vorrichtung
Infrared imaging device with an integrated shield against infrared stray radiations and method for producing said device.

(30) Priorité: 09.06.2011 FR 1101767
(43) Date de publication de la demande: 12.12.2012
(73) Titulaire: Commissariat à l'Énergie Atomique et aux Énergies Alternatives, 75015 Paris (FR); Onera, 92320 Chatillon (FR)
(72) Inventeur: Fendler, Manuel, 38000 GRENOBLE (FR); Druart, Guillaume, 91120 PALAISEAU (FR)
(74) Mandataire: Ilgart, Jean-Christophe

(56) Documents cités:
- US-A1- 2005 078 208
- US-A1- 2006 226 366
- TANIDA J ET AL: "Thin observation module by bound optics (TOMBO): concept and experimental verification", APPLIED OPTICS, OPTICAL SOCIETY OF AMERICA, WASHINGTON, DC; US, vol. 40, no. 11, 10 avril 2001 (2001-04-10), pages 1806-1813, XP002385636, ISSN: 0003-6935, DOI: 10.1364/AO.40.001806

## Description

### DOMAINE TECHNIQUE

La présente invention concerne un dispositif d'imagerie infrarouge à blindage (en anglais, *shield*) intégré contre des rayonnements infrarouges parasites, ainsi qu'un procédé de fabrication de ce dispositif.

Elle s'applique tout particulièrement au domaine des caméras cryogéniques : le détecteur infrarouge d'une caméra de ce type est refroidi pour réduire le bruit thermique des images qu'il fournit ; il doit donc être protégé du rayonnement infrarouge parasite, émis par les parties chaudes du cryostat dans lequel on place la caméra.

### ÉTAT DE LA TECHNIQUE ANTÉRIEURE

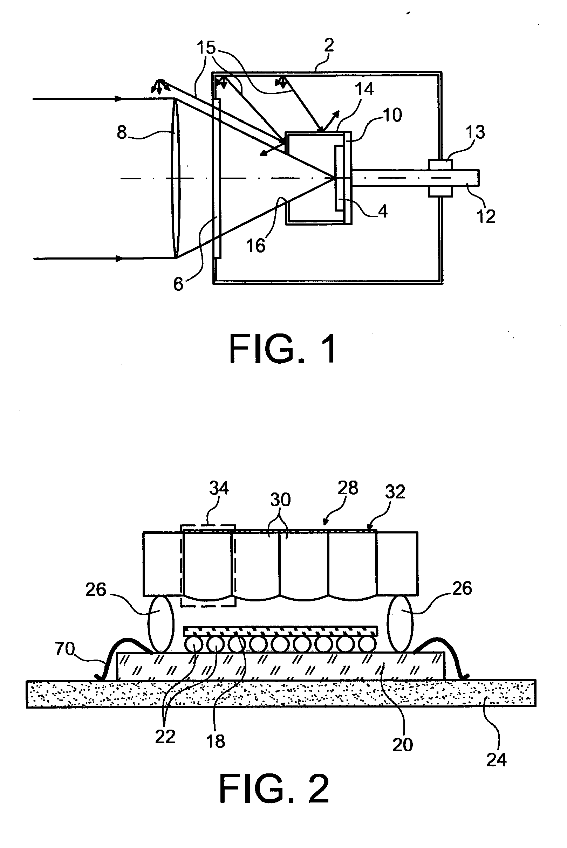

La figure 1 est une vue en coupe schématique d'un cryostat connu 2, contenant une caméra thermique refroidie connue, ou caméra cryogénique. L'intérieur du cryostat est mis sous vide ; la pression résiduelle y vaut typiquement 10⁻⁵ Pa ou moins. Le vide est fait soit une fois pour toutes, ce qui est le cas dans l'exemple de la figure 1, soit de façon dynamique, par l'intermédiaire de moyens appropriés, non représentés.

La caméra cryogénique comprend :
- un dispositif de détection infrarouge 4, placé dans le cryostat 2, en regard d'un hublot 6 dont est pourvu le cryostat, et
- un dispositif optique 8 destiné à former l'image d'une scène observée sur le dispositif de détection infrarouge 4, et placé en regard du hublot 6, à l'extérieur du cryostat 2.

A l'intérieur de ce dernier est prévue une table froide 10 sur laquelle on place le dispositif de détection infrarouge 4. Comme on le voit, cette table froide se prolonge par un doigt froid 12 qui traverse une paroi du cryostat par l'intermédiaire d'un passage hermétique approprié 13.

Ce doigt froid 12 constitue l'extrémité d'une machine cryogénique (non représentée), placée à l'extérieur du cryostat. Cette machine est par exemple une machine cryogénique rotative ou un refroidisseur Stirling ou un tube à gaz pulsé (en anglais, pulse *tube*).

Le dispositif de détection infrarouge 4 est donc refroidi dans le domaine cryogénique, typiquement à une température de 77 K. Cela permet de réduire le bruit thermique au minimum, afin d'obtenir le meilleur rapport signal sur bruit possible.

Le dispositif de détection infrarouge 4 est muni d'un blindage 14 contre des rayonnements infrarouges parasites. Ce blindage est généralement fait en aluminium, métal léger et bon conducteur thermique. Il comporte une ouverture 16 constituant un diaphragme, pour définir l'angle de vue du dispositif de détection infrarouge 4, par exemple 30°.

Ce blindage 14 est prévu pour bloquer ou atténuer la transmission du rayonnement thermique 15, provenant de zones situées en dehors du champ de la caméra, telles que
- les points qui se trouvent en dehors de la scène visée par l'ouverture du dispositif optique 8, et
- les parois chaudes du cryostat, qui sont à température ambiante (environ 20°C).

Le blindage 14 est fixé sur la table froide 10. Il est donc refroidi - c'est pourquoi on lui donne aussi le nom d'écran froid (en anglais, *cold shield*)-pour éviter toute pollution radiative interne.

En fait, le volume occupé par la caméra résulte essentiellement du dispositif optique (situé à l'extérieur du cryostat 2). A titre d'exemple, on se reportera au document suivant :
WO 2006/122907, Optical head for detecting the launch of missiles or other monitoring equipment, Bouchardy et al.

On y voit une caméra à très grand champ, comportant un dispositif optique volumineux.

Cependant, on a de plus en plus besoin de miniaturiser les systèmes optroniques afin de pouvoir les intégrer à des moyens, tels que les aéronefs légers par exemple, qui peuvent seulement recevoir des objets peu volumineux.

Ainsi, l'intégration de fonctions optiques aussi près que possible d'un dispositif de détection est un moyen de concevoir des systèmes complets miniaturisés, ayant une masse de l'ordre de 1 kg ou moins et une taille de l'ordre de 10 cm ou moins, tout en offrant des performances optiques et radiométriques accrues par rapport aux systèmes classiques.

Pendant longtemps il n'a pas été possible d'intégrer, dans un système optronique, des fonctionnalités supplémentaires, permettant de répondre à de vrais besoins opérationnels. Mais, depuis quelques temps, l'intégration de fonctions optiques dans l'espace libre défini par le volume de l'écran froid est envisagée. A ce sujet, on se reportera par exemple au document suivant .
US 2005/0078208, Cold shield for cryogenic camera, Minarik et al.

Rappelons également que l'on connaît une technique de puce retournée (en anglais, *flip chip technique*). Cette technique permet d'assembler et d'interconnecter des puces entre elles ; et, grâce à elle, la hauteur finale d'assemblage est obtenue avec une très grande précision, de l'ordre de 1µm.

Cette technique intéresse donc directement l'optoélectronique, pour le positionnement relatif de dispositifs optiques, et permet, en particulier, d'effectuer un couplage optique en espace libre entre deux dispositifs optiques.

Cette technique peut être appliquée aux dispositifs de détection matriciels. Elle permet, par exemple, de fabriquer le dispositif de détection qui est vu en coupe schématique sur la figure 2.

Ce dispositif est une caméra sur puce infrarouge (en anglais, *infrared camera-on-chip*) et comprend un premier assemblage d'un circuit de détection infrarouge 18, ou rétine infrarouge, sur un circuit de lecture 20. Cet assemblage est effectué par la technique de puce retournée, à l'aide de billes de brasure (en anglais, *solder balls*) 22. Le circuit de lecture 20 est fixé à un substrat en céramique 24 qui constitue un support mécanique et a également pour fonction de servir de référence optique : toutes les optiques sont positionnées par rapport à ce support mécanique.

Grâce à de plus grosses billes de brasure 26, un dispositif optique 28 peut être hybridé au circuit de lecture 20. Ce dispositif optique 28 est destiné à former l'image d'une scène sur le dispositif de détection infrarouge 18. Le dispositif optique 28 comprend par exemple une matrice de microlentilles 30 dont la distance au circuit de détection infrarouge 18 est définie par la hauteur des grosses billes de brasure 26.

Comme on le voit sur la figure 2, la matrice de microlentilles, disposée au dessus du circuit de détection infrarouge 18, constitue un filtre froid diaphragmé du fait d'un masque de trous 32 en métal qu'il comporte.

Une telle architecture résulte de la répétition périodique d'un élément optique monovoie (en anglais, *singlechannel*) diaphragmé 34. Au sujet d'un tel élément, on se reportera au document suivant :
WO 2010/040914, Infrared wide field imaging system integrated in a vacuum housing, Druart et al.

Le dispositif optique 28 permet la miniaturisation de la caméra en rapprochant ce dispositif 28 de la rétine 18 selon un concept de type TOMBO, connu par le document suivant auquel on se reportera :
Jun Tanida et al., Thin observation module by bound optics (TOMBO): concept and experimental verification, Applied Optics, Vol. 40, No. 11, 2001, pp. 1806-1813.

On connaît aussi un détecteur infrarouge par le document US 2006/0226366.

### EXPOSÉ DE L'INVENTION

La présente invention vise à résoudre le problème du blindage d'un dispositif d'imagerie infrarouge contre des rayonnements infrarouges parasites. Ces derniers peuvent comprendre un rayonnement arrivant sur le détecteur à rayonnement infrarouge faisant partie du dispositif et ne provenant pas du champ d'observations, comme un rayonnement parasite frontal.

Plus particulièrement, la présente invention vise à résoudre le problème du blindage d'un tel dispositif d'imagerie contre un rayonnement infrarouge parasite, susceptible de pénétrer latéralement dans l'espace compris entre le détecteur de rayonnement infrarouge et le dispositif optique qui font partie du dispositif d'imagerie infrarouge.

De façon précise, la présente invention a pour objet un dispositif d'imagerie infrarouge, comprenant :
- un support, comprenant un détecteur de rayonnement infrarouge qui comporte une zone sensible au rayonnement infrarouge,
- au moins un dispositif optique, placé en regard du détecteur de rayonnement infrarouge, et
- un dispositif de blindage contre des rayonnements infrarouges parasites, à savoir un rayonnement parasite frontal, susceptible de pénétrer dans un espace compris entre le support et le dispositif optique, à travers ce dernier, et un rayonnement parasite latéral, susceptible de pénétrer latéralement dans cet espace,
   **caractérisé en ce que** le dispositif de blindage comprend au moins un ensemble de blindage comportant N cordons continus, espacés les uns des autres, pourvus chacun d'un évent et faits d'un matériau apte à atténuer significativement le rayonnement parasite latéral, et chacun des N cordons s'étend du support jusqu'au dispositif optique, où N est un nombre entier au moins égal à 2, dans lequel le cordon de rang 1 entoure au moins la zone sensible du détecteur de rayonnement infrarouge, le cordon de rang i entoure le cordon de rang i-1, pour i allant de 2 à N, et les N cordons, pourvus de leurs évents respectifs, forment au moins une chicane dans laquelle les évents de cordons de rangs successifs ne sont pas en regard l'un de l'autre.

On précise que l'atténuation du rayonnement parasite latéral est supérieure à 80% et que le matériau dont sont faits les cordons est choisi de manière à être assez diffusant pour éviter d'avoir à utiliser un nombre trop important de cordons.

On précise en outre que :
- les évents permettent l'évacuation de l'air qui se trouve entre le dispositif optique et le détecteur de rayonnement infrarouge, lors de la mise sous vide du dispositif d'imagerie infrarouge, et
- l'espace compris entre deux cordons consécutifs constitue une zone de guidage du rayonnement parasite qui a pu pénétrer dans cet espace ; ce rayonnement est alors guidé entre les parois des cordons et son intensité diminue au fur et à mesure de sa progression entre les parois.

L'invention présente des avantages .
- elle permet d'éviter d'utiliser de la colle pour coller le support du détecteur de rayonnement infrarouge au support du dispositif optique ; et
- elle permet de s'affranchir du problème de la fiabilité d'un collage uniforme entre le support du détecteur et le support du composant ; en effet, dans la présente invention, on ne cherche pas à obtenir un scellement hermétique, d'autant plus que l'on mettra sous vide la zone où se trouve le détecteur de rayonnement infrarouge.

Selon un mode de réalisation préféré du dispositif d'imagerie infrarouge, objet de l'invention, dans chaque ensemble de blindage, les évents respectifs des cordons de rangs i et i+1, pour i allant de 1 à N-1, sont à 180° l'un de l'autre.

De préférence, la taille de chaque évent est dans l'intervalle [1 µm ; 10 µm].

Selon un mode de réalisation particulier du dispositif, objet de l'invention, le nombre N est au moins égal à 3.

De préférence, dans chaque ensemble de blindage, l'espacement des cordons consécutifs est dans l'intervalle [1 µm ; 10 µm].

Dans la présente invention, les cordons sont avantageusement des cordons de brasure (en anglais, *solder*).

Selon un premier mode de réalisation préféré de l'invention, le dispositif optique comporte des première et deuxième faces opposées, la deuxième face est en regard du détecteur de rayonnement infrarouge, et le dispositif de blindage comprend en outre une couche qui est formée sur la première face, est faite d'un matériau apte à atténuer le rayonnement parasite frontal, et comporte des ouvertures.

De préférence, ledit dispositif optique comprend sur ses côtés un matériau apte à empêcher la transmission du rayonnement parasite latéral.

Selon un deuxième mode de réalisation préféré de l'invention, le dispositif d'imagerie infrarouge comporte M dispositifs optiques, le dispositif de blindage comprend M ensembles de blindage, où M est un nombre entier au moins égal à 2, chaque dispositif optique comporte des première et deuxième faces opposées, la deuxième face du dispositif optique de rang 1 est en regard du détecteur de rayonnement infrarouge, la deuxième face du dispositif optique de rang j est en regard de la première face du dispositif optique de rang j-1, l'ensemble de blindage de rang 1 s'étend du support jusqu'au dispositif optique de rang 1, et l'ensemble de blindage de rang j s'étend du dispositif optique de rang j-1 au dispositif optique de rang j, pour j allant de 2 à M, le dispositif de blindage comprend en outre une couche qui est formée sur la face avant du dispositif optique de rang M, et cette couche est faite d'un matériau apte à atténuer le rayonnement parasite frontal et comporte des ouvertures.

Selon, un mode de réalisation particulier de l'invention, le support comprend en outre un substrat et un circuit de lecture sur le substrat, le détecteur de rayonnement infrarouge est hybridé au circuit de lecture par des billes de brasure, et le dispositif optique le plus proche du substrat est relié à l'un des éléments choisis parmi le détecteur de rayonnement infrarouge, le circuit de lecture et le substrat, par l'intermédiaire d'un ensemble de blindage.

Selon un autre mode de réalisation particulier, le support comprend en outre un réseau d'interconnexion entre le substrat et le circuit de lecture, et le dispositif optique le plus proche du substrat est relié à l'un des éléments choisis parmi le détecteur de rayonnement infrarouge, le circuit de lecture, le substrat, et le réseau d'interconnexion, par l'intermédiaire d'un ensemble de blindage.

Selon un autre mode de réalisation particulier, au moins un dispositif optique comprend une matrice de microlentilles définissant des voies de détection élémentaires, et le dispositif d'imagerie comprend en outre un ensemble de parois faites d'un matériau apte à atténuer significativement les rayonnements parasites, disposées entre la matrice de microlentilles et le détecteur et destinées à séparer les voies élémentaires les unes des autres.

La présente invention concerne aussi un procédé de fabrication du dispositif d'imagerie infrarouge, objet de l'invention, dans lequel :
- on forme l'ensemble de blindage sur le support comprenant le détecteur de rayonnement infrarouge,
- on place le dispositif optique en regard du détecteur de rayonnement infrarouge, et
- on fixe le dispositif optique à l'ensemble de blindage.

Selon un mode de réalisation préféré du procédé de fabrication :
- on assemble le détecteur de rayonnement infrarouge au support par la technique de puce retournée,
- on utilise des cordons de brasure pour former l'ensemble de blindage, et
- on fixe le dispositif optique aux cordons de brasure par la technique de puce retournée.

### BRÈVE DESCRIPTION DES DESSINS

La présente invention sera mieux comprise à la lecture de la description d'exemples de réalisation donnés ci-après, à titre purement indicatif et nullement limitatif, en faisant référence aux dessins annexés sur lesquels :
- la figure 1 est une vue en coupe schématique d'un cryostat connu, contenant une caméra cryogénique connue, et a déjà été décrite,
- la figure 2 est une vue en coupe schématique d'une caméra sur puce infrarouge et a déjà été décrite,
- les figures 3A et 3B sont des vues de dessus schématiques de blindages utilisables dans l'invention contre un rayonnement infrarouge parasite latéral,
- la figure 4 illustre schématiquement la diminution progressive de l'intensité de ce rayonnement à l'aide de tels blindages,
- la figure 5 est une vue en coupe schématique d'un exemple de voie optique élémentaire d'une matrice de microlentilles, utilisable dans l'invention,
- la figure 6 est une vue en coupe schématique d'un mode de réalisation particulier du dispositif d'imagerie infrarouge, objet de l'invention,
- la figure 7 est une vue en coupe schématique d'un exemple de dispositif d'imagerie infrarouge classique,
- les figures 8 et 9 sont des vues en coupe schématiques d'autres modes de réalisation particuliers du dispositif d'imagerie infrarouge, objet de l'invention,
- les figures 10A, 10B, 11A, 11B, 12A, 12B, 13A et 13B illustrent schématiquement des étapes d'un procédé de fabrication d'un exemple du dispositif d'imagerie infrarouge, objet de l'invention, la lettre A correspondant à des vues de dessus et la lettre B à des vues en coupe, et
- les figures 14A à 14F et 15A à 15C illustrent schématiquement des étapes de la technique d'assemblage par puce retournée.

### EXPOSÉ DÉTAILLÉ DE MODES DE RÉALISATION PARTICULIERS

On donne ci-après divers exemples de l'invention. Ces exemples utilisent la caméra sur puce qui a été décrite en faisant référence à la figure 2.

Conformément à l'invention, on modifie cette caméra en vue de blinder celle-ci contre le rayonnement infrarouge parasite, tissu :
- de l'enceinte cryogénique, ou cryostat (non représenté), dans lequel on place la caméra lorsqu'on l'utilise, et
- de ce qui est en dehors du champ d'observation dans la scène en regard de laquelle est placée la caméra.

On définit un rayonnement infrarouge parasite frontal comme étant un rayonnement infrarouge parasite, susceptible de pénétrer dans l'espace compris entre le dispositif optique rapporté 28 (figure 2) et le circuit de détection infrarouge 18 en traversant ce dispositif optique 28.

On définit également un rayonnement infrarouge parasite latéral comme étant un rayonnement infrarouge parasite, susceptible de pénétrer latéralement dans cet espace, entre les grosses billes de brasure 26 ayant servi à l'hybridation du dispositif optique 28 au circuit de lecture 20.

La configuration de la caméra sur puce offre une propriété intrinsèque de protection : le dispositif optique rapporté 28 permet de blinder la caméra contre le rayonnement infrarouge parasite frontal grâce à la face diaphragmée de ce dispositif optique 28, à savoir la face sur laquelle se trouve le masque de trous 32. Ainsi, il ne reste plus qu'à protéger la caméra sur puce du rayonnement infrarouge parasite latéral.

Conformément à l'invention, au lieu d'utiliser les grosses billes de brasure 26, on utilise un cordon périphérique de brasure, formant un joint continu, pour constituer le blindage optique latéral.

Pour le report de la matrice de microlentilles, constituant le dispositif optique 28, on réalise ainsi un cordon continu de brasure dont la hauteur, après solidification, est définie :
- par le volume de brasure qui est mis en oeuvre avant la refusion de la brasure (en anglais, *solder reflow*), et
- par les surfaces mouillables en regard les unes des autres.

On exploite dans ce cas les règles classiques de l'hybridation, qui utilisent l'équilibre des tensions de surface d'une brasure fondue. A ce sujet, on pourra se reporter au document suivant :
G. Humpston et D. Jacobson, Principles of soldering, pp. 189-242, ASM International, 2004.

En fait, pour permettre l'évacuation de l'air qui se trouve entre le dispositif optique et le circuit de détection, lors de la mise sous vide du cryostat, il faut prévoir, dans le cordon, un évent permettant cette évacuation.

De plus, pour effectuer un bon blindage optique, minimisant l'introduction d'un rayonnement parasite, on prévoit non pas un mais au moins deux cordons de brasure, respectivement pourvus d'évents. Et l'on place les évents de façon que les cordons, respectivement pourvus de ces évents, forment au moins une chicane dans laquelle le rayonnement parasite résiduel sera piégé. Par exemple, dans le cas où l'on prévoit seulement deux cordons, les évents correspondants ne sont pas en regard l'un de l'autre.

Toutefois, pour des composants très sensibles, nécessitant un très faible rapport signal sur bruit, on peut être amené à utiliser plus de deux cordons et à augmenter le nombre de chicanes en disposant les cordons de manière appropriée.

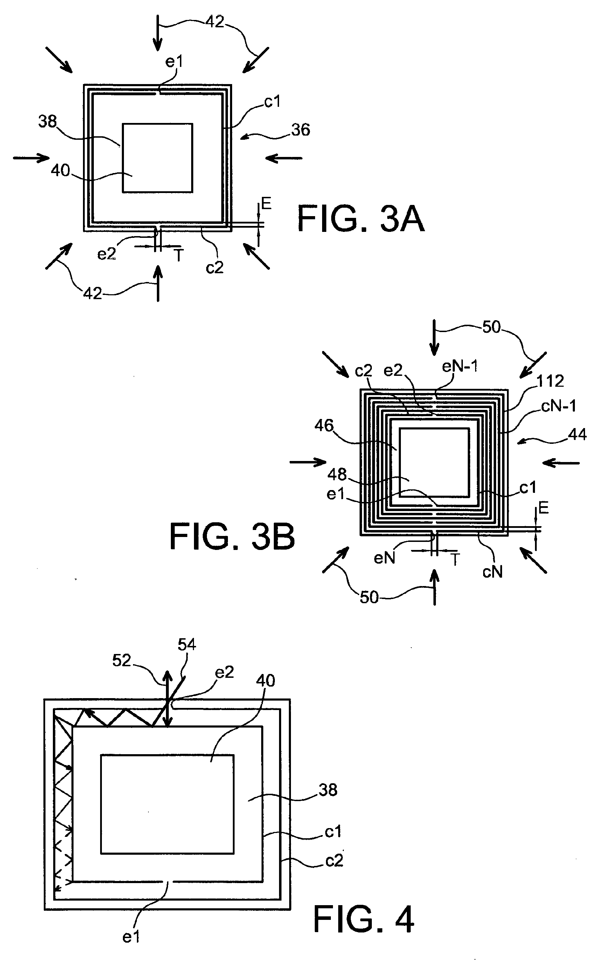

Les figures 3A et 3B sont des vues de dessus schématiques d'exemples de blindage contre le rayonnement infrarouge parasite latéral.

Le blindage 36, ou ensemble de blindage, représenté sur la figure 3A, fait partie d'un dispositif d'imagerie infrarouge conforme à l'invention, dont on ne voit que le circuit de lecture 38 et le détecteur de rayonnement infrarouge 40, hybridé au circuit de lecture 38.

L'ensemble de blindage 36 est destiné à atténuer un rayonnement infrarouge parasite latéral 42 et se compose de deux cordons de brasure c1 et c2 qui sont respectivement pourvus d'évents e1 et e2. Le cordon c1 entoure le détecteur 40 et le cordon c2 entoure le cordon c1.

Les évents e1 et e2 sont disposés de façon que les deux cordons, pourvus de ces évents, forment une chicane. Les deux évents ne sont donc pas en regard l'un de l'autre ; dans l'exemple représenté, ils sont à 180° l'un de l'autre ; on verra pourquoi par la suite.

Le blindage 44, ou ensemble de blindage, représenté sur la figure 3B, fait partie d'un dispositif d'imagerie infrarouge conforme à l'invention, dont on ne voit que le circuit de lecture 46 et le détecteur de rayonnement infrarouge 48, hybridé au circuit de lecture 46.

L'ensemble de blindage 44 est destiné à atténuer un rayonnement infrarouge parasite latéral 50 et se compose de N cordons de brasure c1, c2, ... , cN-1, cN qui sont respectivement pourvus d'évents e1, e2, ... , eN-1, eN, où N est nombre entier au moins égal à 3. Dans l'exemple représenté, le nombre N est égal à 7. Le cordon c1 entoure le détecteur 40 ; le cordon c2 entoure le cordon c1 ; etc... ; le cordon cN entoure le cordon cN-1.

Les N évents e1 à eN sont disposés de façon que les N cordons c1 à cN, pourvus de ces évents, forment au moins une chicane : on peut par exemple avoir N-1 évents en regard les uns des autres (tous étant d'un même côté du détecteur) et un évent qui n'est pas en regard de ces N-1 évents et qui est par exemple à 180° de ceux-ci (et donc à l'opposé de ceux-ci par rapport au détecteur).

Mais, de préférence, comme le montre la figure 3B, il y a plusieurs chicanes et les évents respectifs de deux cordons consécutifs sont encore à 180° l'un de l'autre : l'évent e1 est à 180° de l'évent e2, etc..., l'évent eN-1 est à 180° de l'évent eN.

De préférence, les ouvertures constituées par les évents ont des tailles telles que le rayonnement parasite entrant dans les chicanes formées par ces évents soit le plus faible possible. Typiquement, on donne à ces ouvertures une taille T qui va de 1µm à 10µm.

De préférence, l'espace E entre deux cordons consécutifs va également de 1µm à 10µm.

I1 est préférable que les positions respectives des évents soient opposées pour que le trajet du rayonnement parasite entrant soit le plus long possible. De ce fait, on profite au mieux des pertes d'intensité de ce rayonnement qui est guidé entre les parois des cordons de brasure : ces parois comportent des rugosités qui diffusent le rayonnement parasite ; ainsi l'intensité de celui-ci diminue lors de ses réflexions successives sur les parois.

Ceci est schématiquement illustré par la figure 4 où l'on a repris l'exemple illustré par la figure 3A.

On voit un rayonnement parasite 52 qui pénètre entre les deux cordons c1 et c2 sous incidence normale. Ce rayonnement est ainsi rejeté à l'extérieur de la zone délimitée par les deux cordons. On voit aussi un rayonnement parasite 54 qui est guidé entre les parois des deux cordons et qui est donc piégé dans la chicane formée par ces cordons. L'intensité de ce rayonnement 54 diminue au fur et à mesure de sa progression entre les parois.

L'épaisseur et la hauteur des cordons de brasure sont directement liées à l'architecture optique mise en ouvre. Dans le cadre d'une approche « caméra sur puce », l'ingénierie optique mène à un dimensionnement obtenu par lancer de rayon (en anglais, *ray-tracing*)*.*

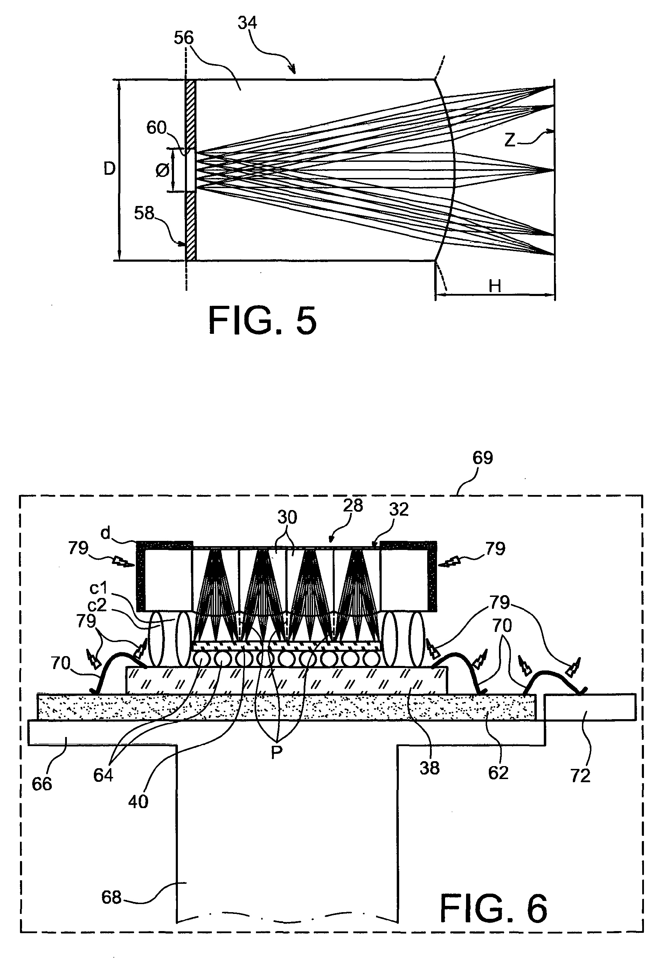

La figure 5 est une vue en coupe schématique d'un exemple de voie optique élémentaire 34 de la matrice de microlentilles (figure 2). La conception de cette voie élémentaire est effectuée avec un logiciel de lancer de rayon commercial de type Zemax^{®}, ou Oslo^{®} ou CODE V^{®}.

Cette voie optique élémentaire se caractérise par une microlentille 56 qui est placée à une distance H de la zone sensible Z du détecteur de rayonnement infrarouge 40 (figure 3A) ou 48 (figure 3B), zone qui est sensible au rayonnement infrarouge.

La distance H est directement liée à la distance focale de cette microlentille. Dans l'exemple représenté, cette distance H est comprise entre 0 et 1mm.

On voit aussi une partie 58 du masque de trous 32 de la figure 2. Cette partie constitue un diaphragme métallique, pourvu d'une ouverture 60. La dimension D de ce diaphragme est supérieure à la taille d'un pixel de la zone sensible Z et inférieure à la taille du détecteur ; et dans l'exemple, le diamètre Ø de l'ouverture 60 est compris entre 0,1µm et D.

L'épaisseur et la hauteur des cordons de brasure, définies par la quantité de brasure et par la surface mouillable, permettent de positionner très précisément le dispositif optique au dessus du détecteur par la technique de puce retournée (en anglais, *flip chip technique*).

La figure 6 est une vue en coupe schématique de l'exemple du dispositif d'imagerie infrarouge, objet de l'invention, auquel on aboutit. Il s'agit d'une caméra sur puce qui est blindée contre les rayonnements infrarouges parasites frontal et latéral.

En reprenant certaines des notations des figures 2 et 3A, on voit ainsi sur la figure 6:
- un substrat 62, par exemple en céramique,
- le circuit de lecture 38, porté par ce substrat,
- le détecteur de rayonnement infrarouge 40, hybridé au circuit de lecture par des billes de brasure 64,
- un ensemble P de parois permettant d'isoler optiquement chaque voie optique,
- le dispositif optique 28, comprenant la matrice des microlentilles 30, et
- un dispositif de blindage contre les rayonnements infrarouges parasites frontal et latéral.

Ce dispositif de blindage comprend :
- le masque de trous 32, porté par une première face du dispositif optique 28, dont la deuxième face, opposée à la première face, est en regard du détecteur de rayonnement infrarouge 40 ;
- un dépôt d, sur les côtés du dispositif optique 28, d'un matériau empêchant la transmission du rayonnement parasite latéral ; de manière générale, il suffit que ledit dispositif optique comprenne, sur ses côtés, un matériau apte à empêcher la transmission du rayonnement parasite latéral ; et
- un ensemble de blindage formé par les deux cordons de brasure continus c1 et c2 qui s'étendent, dans l'exemple représenté, du circuit de lecture 38 au dispositif optique 28.

On voit aussi une table froide 66 sur laquelle repose le substrat de céramique 62 et qui se prolonge par un doigt froid 68 ; mais on n'a pas représenté la machine permettant de porter le doigt froid, la table froide et donc le dispositif d'imagerie à une température cryogénique, par exemple 77K.

Cependant, on a symbolisé par des pointillés 69 le cryostat dans lequel on place ce dispositif d'imagerie lorsqu'on l'utilise. Un hublot (non représenté) est alors prévu sur la paroi du cryostat, en regard de laquelle on dispose le dispositif optique 28.

On voit en outre des portions d'un câblage filaire 70 qui permet de relier électriquement le circuit de lecture 28 à un câblage de sortie 72. Ce dernier est destiné à connecter le circuit de lecture 38 à des moyens électroniques de commande (non représentés) du dispositif d'imagerie, qui sont placés à l'extérieur du cryostat (mais pourraient également être placés à l'intérieur de ce dernier).

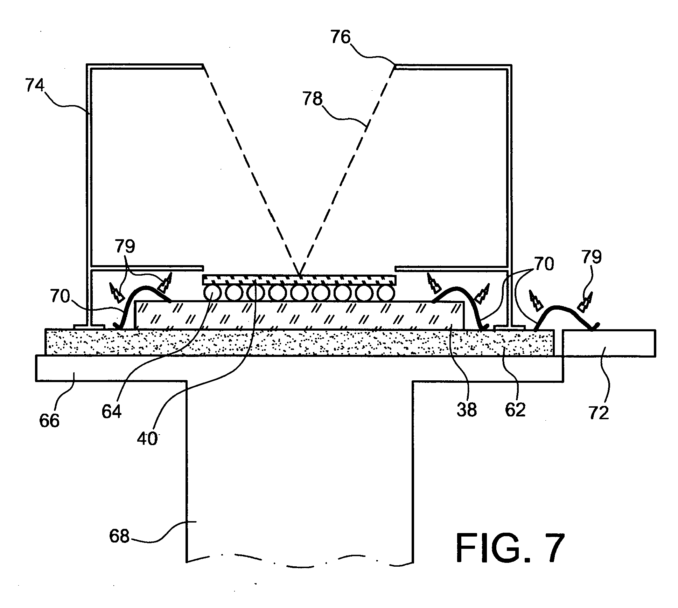

La figure 7 est une vue en coupe schématique d'un exemple de dispositif d'imagerie infrarouge classique. Sur cette figure 7, on retrouve le détecteur de rayonnement infrarouge 40, hybridé au circuit de lecture 38, le substrat 62 portant le circuit de lecture, la table froide 66 prolongée par le droit froid 68, le câblage filaire 70 et le câblage de sortie 72.

Dans le cas de la figure 7, la protection du détecteur 40 contre les rayonnements infrarouges parasites est assurée par un écran froid 74. En regard du détecteur 40, cet écran froid comporte une ouverture 76 qui définit un angle de vue 78.

On n'a pas représenté le cryostat dans lequel on place le dispositif de la figure 7 en vue de son utilisation. Ce cryostat est pourvu d'un hublot en regard de l'ouverture 76. Et le dispositif d'imagerie comporte une optique (non représentée), placée à l'extérieur du cryostat, en regard du hublot.

Si l'on compare l'une à l'autre les figures 6 et 7, on voit que l'écran froid du dispositif de la figure 7 est remplacé, dans le dispositif de la figure 6 :
- par un blindage supérieur, formé sur le dispositif optique et constitué par le masque de trous 32, à savoir une couche pourvue d'ouvertures et faite d'un matériau qui arrête le rayonnement infrarouge parasite frontal, pour protéger le détecteur contre ce rayonnement,
- par un dépôt d, sur les côtés du dispositif optique 28, empêchant la transmission du rayonnement parasite latéral, et
- par un blindage périphérique, formé par les deux cordons de brasure c1 et c2 qui protègent le détecteur contre le rayonnement infrarouge parasite latéral, notamment contre le rayonnement 79 résultant du passage du courant dans le câblage filaire 70.

Des variantes de la configuration « caméra-sur-puce » sont envisageables, en considérant le fait que les cordons de brasure périphériques peuvent être réalisés sur tout support positionné sous le détecteur, à condition que ce dernier soit toujours protégé contre les rayonnements parasites.

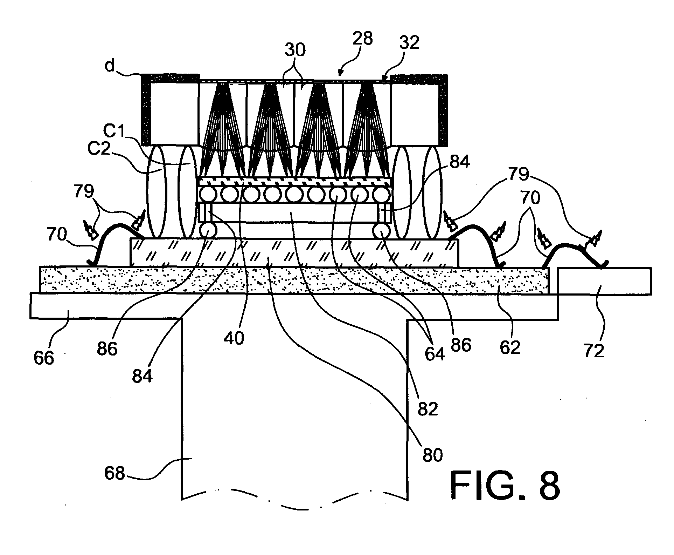

Si l'on imagine par exemple une configuration de type Système dans un Boîtier (en anglais, *System-in-Package*), comportant un empilement de puces qui sont interconnectées au moyen de vias traversants (en anglais, *through-silicon vias*), on aboutit à une autre structure conforme à l'invention. Cette autre structure est vue en coupe schématique sur la figure 8.

Comme on le voit, le dispositif représenté sur cette dernière se distingue de celui qui est représenté sur la figure 6 par le fait qu'il comprend en outre un réseau d'interconnexion 80. Ce dernier repose sur le substrat 62.

Le détecteur 40 est hybridé à un circuit de lecture 82, homologue du circuit de lecture 38 de la figure 6, par l'intermédiaire des billes de brasure 64. Ce circuit de lecture comporte des vias traversants 84 qui sont hybridés au réseau d'interconnexion par l'intermédiaire d'autres billes de brasure 86.

De plus, dans le cas de la figure 8, les cordons de brasure C1 et C2, homologues des cordons c1 et c2 de la figure 6, vont du réseau d'interconnexion 80 au dispositif optique 28. Et le câblage de sortie 72 est à présent relié au réseau d'interconnexion 80 par l'intermédiaire du câblage filaire 70.

De manière générale, les cordons supportant le dispositif optique diaphragmé peuvent être positionnés sur n'importe quel support, y compris le substrat 62 et le détecteur 40 lui-même, à condition que ces cordons soient en contact (indirect) avec le doigt froid 68 et assurent la protection du détecteur 40 vis-à-vis des sources de rayonnement infrarouge parasite dans le cryostat (notamment le câblage filaire et les parois chaudes du cryostat) lorsque le dispositif d'imagerie s'y trouve en vue d'être utilisé.

Dans le cas où l'on souhaite positionner les cordons sur un substrat de céramique, on prévoit sur ce dernier des zones métalliques appropriées sur lesquelles peut adhérer la brasure.

Dans le cas où l'on souhaite positionner les cordons sur le détecteur, on fait en sorte que les cordons entourent la zone sensible de celui-ci, c'est-à-dire l'ensemble des pixels de détection du rayonnement infrarouge.

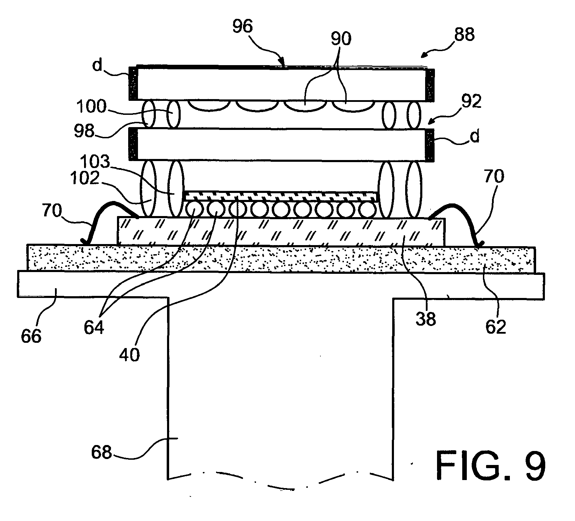

On peut également concevoir un dispositif conforme à l'invention, comprenant un ensemble de plusieurs étages optiques, empilés verticalement au moyen de cordons de brasure intermédiaires. Ceci est schématiquement illustré par la figure 9 qui est une vue en coupe schématique d'un autre exemple de l'invention.

Dans le cas de la figure 9, on utilise :
- M dispositifs optiques, parmi lesquels le plus éloigné du détecteur de rayonnement infrarouge est pourvu d'un masque de trous permettant d'arrêter un rayonnement infrarouge parasite frontal, et
- M ensembles de blindage, permettant d'atténuer un rayonnement infrarouge parasite latéral, où M est un nombre entier supérieur à 1.

Dans l'exemple, M est égal à 2 et chaque ensemble de blindage comprend deux cordons de brasure respectivement pourvus d'évents (non représentés), comme dans le cas de la figure 3A.

En fait, comme on le voit, le dispositif d'imagerie représenté sur la figure 9 se distingue de celui qui est représenté sur la figure 6 par le fait qu'il comprend non pas un, mais deux dispositifs optiques, chacun de ceux-ci pouvant avoir une fonction d'imagerie ou une fonction de filtrage spectral. Ces deux fonctions peuvent d'ailleurs être jouées par un même dispositif optique (en vue d'une limitation du nombre de dispositifs optiques) dont au moins un dioptre aurait été formé pour avoir une fonction d'imagerie et aurait reçu un traitement limitant la bande spectrale, ou encore un traitement anti-reflet par exemple.

Sur les figures 6 et 9, les mêmes éléments ont les mêmes références. Le dispositif d'imagerie de la figure 9 comprend un premier dispositif optique 88, comprenant une matrice de microlentilles 90 ayant une fonction d'imagerie, et un deuxième dispositif optique 92 ayant une fonction de filtre froid, compris entre le dispositif 90 et le détecteur 40.

De plus, la face inférieure du dispositif 88 est reliée à la face supérieure du dispositif 92 par deux cordons de brasure 98 et 100, et la face inférieure du dispositif 92 est reliée au circuit de lecture 38 par deux cordons de brasure 102 et 103. Et comme on le voit, les côtés des dispositifs 88 et 92 sont encore pourvus de dépôts d empêchant la transmission du rayonnement parasite latéral.

L'ensemble de diaphragmes, du genre du masque de trous 96 dont est pourvue la face supérieure du dispositif 88, peut être obtenu à l'aide d'un dépôt métallique sur la face supérieure du dispositif optique qui est pourvu de ce masque de trous.

De plus, dans l'invention, l'architecture optique n'est pas nécessairement une architecture de type TOMBO (pour la signification de cet acronyme, voir l'article de Jun Tanda et al., cité plus haut).

On a décrit une technique de puce retournée pour réaliser les cordons continus pourvus d'évents. Cette technique est très performante en termes de positionnement et de conductibilité thermique.

Mais tout type de report sur des matériaux différents de ceux qui sont utilisés pour la mise en oeuvre de la technique de puce retournée, par exemple des polymères conducteurs ou des nanomatériaux, et permettant un positionnement précis du dispositif optique grâce aux propriétés des matériaux utilisés et/ou aux machines de positionnement, permettront d'aboutir au même résultat de blindage.

De plus, les dispositifs optiques que l'on a considérés dans les exemples donnés plus haut sont des matrices de microlentilles. Mais la présente invention peut être mise en oeuvre avec tout autre dispositif optique devant être placé en regard d'un détecteur de rayonnement infrarouge, par exemple des optiques monovoies, des filtres, des réseaux de diffraction, etc...

En outre, dans les exemples donnés plus haut, on a utilisés des masques de trous pour le blindage du détecteur contre le rayonnement infrarouge parasite frontal. Mais, contre ce dernier, d'autres blindages sont possible, par exemple un masque codé, un diaphragme, un iris, etc...

Il convient de noter que l'invention présente les avantages particuliers suivants :
- elle n'utilise pas l'écran froid qui est une pièce volumineuse ;
- elle permet la diminution du volume du cryostat, d'où l'intérêt de l'invention pour une intégration à des moyens, tels que les aéronefs légers par exemple, qui peuvent seulement recevoir des objets peu volumineux ; et
- elle permet la diminution du temps qui est nécessaire pour atteindre la température cryogénique de fonctionnement, par exemple 77K, du fait de la diminution de la masse devant être refroidie.

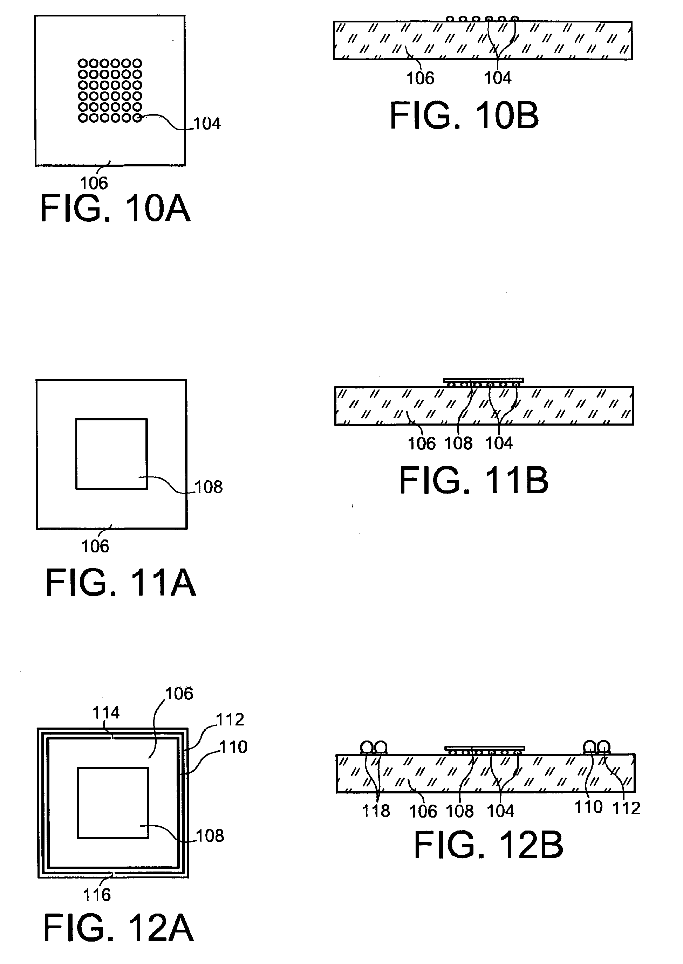

On décrit ci-après des étapes d'un procédé de fabrication d'un exemple du dispositif d'imagerie, objet de l'invention, en faisant référence aux figures 10A à 13B. Chacune de ces étapes fait appel à la technique d'assemblage par puce retournée sur laquelle on reviendra par la suite.

Les figures affectées de la lettre A correspondent à des vues de dessus schématiques et les figures affectées de la lettre B à des vues en coupe schématiques.

On commence par former un ensemble de billes de brasure 104 sur un circuit de lecture 106, ou sur tout autre circuit-hôte, en vue d'hybrider un détecteur de rayonnement infrarouge à ce circuit de lecture (figures 10A et 10B).

On fabrique ensuite un système d'imagerie par exemple de type IRCMOS (pour *InfraRed Complementary Metal Oxide Semiconductor*) par hybridation d'un circuit de détection infrarouge approprié 108 sur le circuit de lecture 106 au moyen des billes de brasure 104 (figures 11A et 11B). On précise que l'on n'a pas représenté les plots (en anglais, *pads*) métalliques dont sont respectivement pourvus les circuits 106 et 108 et auxquels adhère la brasure.

On forme ensuite deux cordons périphériques continus de brasure 110 et 112, respectivement pourvus d'évents 114 et 116, sur le circuit de lecture 106, autour du détecteur 108 (figures 12A et 12B), ce qui conduit à une structure du genre de celle que l'on voit sur la figure 3A.

On précise que le circuit de lecture 106 a préalablement été pourvu de surfaces métalliques appropriées 118, mouillables par la brasure, en vue de recevoir cette dernière pour former les deux cordons. On précise en outre que les évents sont formés en même temps que les cordons : le masque de photolithographie utilisé pour cette formation est prévu à cet effet.

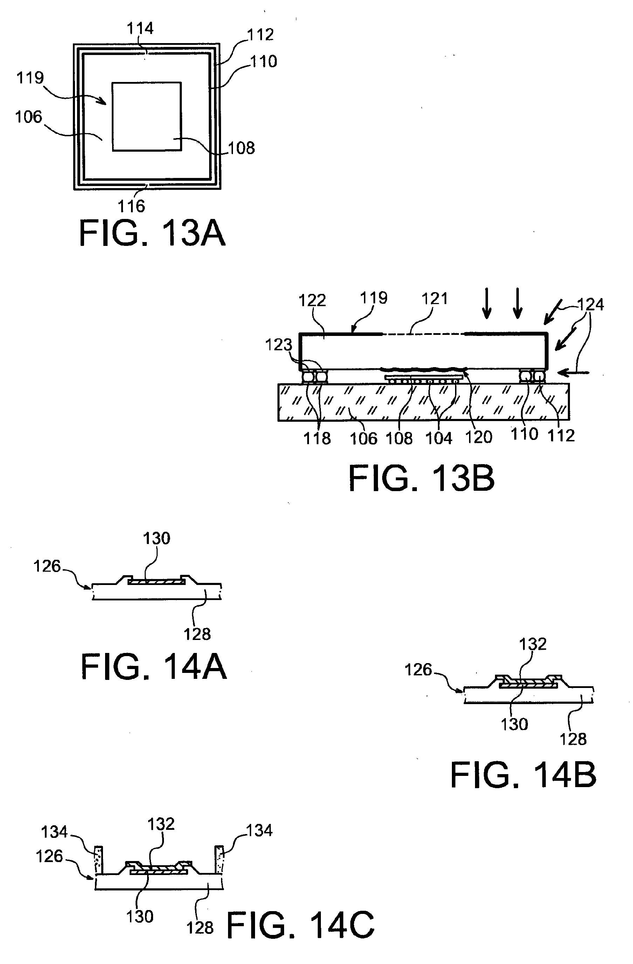

On procède ensuite à l'hybridation d'un dispositif optique 119 sur le circuit de lecture 106 (figures 13A et 13B). On voit que ce dispositif optique 119 est sensiblement du genre du dispositif 28 de la figure 6. Il comporte des microlentilles 120 et un masque de trous 121 (ensemble de diaphragmes) ainsi qu'un blindage périphérique 122 (métallisation) ; il est en outre préalablement pourvu de surfaces métalliques appropriées 123, mouillables par la brasure, en vue de l'hybridation.

La structure obtenue est alors protégée contre des rayonnements infrarouges parasites 124.

On a donc obtenu un dispositif du genre de celui qui est représenté sur la figure 6. L'homme du métier peut bien entendu adapter le procédé que l'on vient de décrire, pour former des dispositifs du genre de ceux qui sont représentés sur les figures 8 et 9.

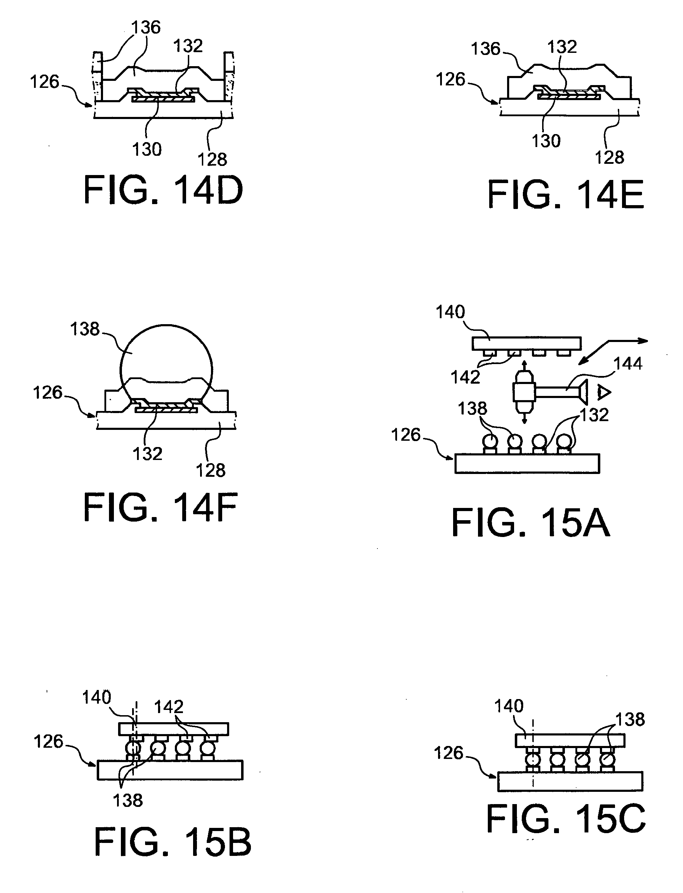

On rappelle brièvement, ci-après, diverses étapes de la technique d'assemblage par puce retournée, en faisant référence aux vues en coupe schématiques et partielles des figures 14A à 14F et 15A à 15C.

On commence par pourvoir un composant 126, par exemple un circuit CMOS sortant de fonderie, de zones de passivation, telles que la zone 128, et de disques métalliques par exemple en aluminium, tels que le disque 130, dans ces zones (figure 14A). On dépose ensuite des surfaces mouillantes, telles que la surface 132, sur les disques métalliques (figure 14B).

Puis on procède à une photolithographie en vue de définir les volumes utiles de brasure, par exemple l'indium, dont on a besoin sur les surfaces mouillantes, au moyen d'éléments de résine photosensible tels que l'élément 134 (figure 14C). Ensuite, on dépose la brasure et l'on forme ainsi les volumes utiles de brasure tels que le volume 136 (figure 14D).

Puis on procède à un pelage (en anglais, *lift* off) pour éliminer la résine photosensible (figure 14E). Et l'on procède à une refusion pour former les billes de brasure, telles que la bille 138, sur leurs surfaces mouillantes respectives (figure 14F).

On vient donc de décrire une technique de formation de billes de brasure, qui utilise un pelage. Mais d'autres techniques de formation de billes sont utilisables : on peut par exemple procéder par transfert de billes discrètes, jet d'encre, électrolyse ou photolithogravure.

Toutes ces techniques ont pour point commun le fait que la morphologie de chaque bille (diamètre, hauteur) dépend du volume de matière déposé - la quantité d'indium dans l'exemple - et de la taille de la surface mouillable (future base de la bille refondue).

Ensuite, on procède à l'hybridation d'un autre composant 140, pourvu de plots 142, au composant 126.

On commence par aligner les deux composants 126 et 140, par exemple au moyen d'un dispositif de connexion par billes (en anglais, *flip-chip bonder*), utilisant un microscope approprié 144. On utilise par exemple le dispositif commercialisé par la Société SET sous la référence FC 150 (figure 15A).

Ensuite, on positionne les plots 142 du composant 140 sur les billes de brasure correspondantes 138 du composant 126 (figure 15B). Et l'on procède à la refusion des billes 138, d'où un auto-alignement des composants 126 et 140 (figure 15C).

Revenons sur le dispositif optique utilisé dans l'invention.

Ce dispositif optique n'est pas nécessairement rigide : dans l'invention, il est possible d'utiliser un dispositif optique souple que l'on souhaite rendre courbe en utilisant des cordons de tailles différentes pour aider à le courber, tout en préservant le blindage contre les rayonnements infrarouges parasites, blindage qui résulte des cordons.

De plus, dans les exemples donnés plus haut, on a utilisé des cordons de brasure, mais d'autres types de cordons sont possible. :
On peut par exemple utiliser des cordons tubulaires qui sont encore pourvus desdits évents, sont encore faits d'un matériau, par exemple un métal, qui atténue le rayonnement infrarouge, et s'emboîtent les uns dans les autres.

Par exemple, en reconsidérant le cas de la figure 6, on peut remplacer le cordon c2 par une première portion de tube, portée par le circuit 38, et le cordon c1 par une deuxième portion de tube, portée par le composant 28 et s'emboîtant dans la première portion.

En outre, dans le cas particulier d'un dispositif optique à voies multiples, une partie du flux de rayonnement infrarouge qui est en dehors du champ du dispositif d'imagerie n'est pas écranté par le diaphragme dont est pourvu le dispositif optique (masque de trous 32 dans l'exemple de la figure 6), et peut donc se focaliser sur une zone du détecteur qui est dédiée aux voies adjacentes à une voie donnée.

Dans ce cas, les flancs des différentes voies peuvent être traités pour y former des dépôts métalliques, afin de contenir ce rayonnement parasite inter-voies.

Ceci est schématiquement illustré sur la figure 6 où l'on voit l'ensemble de parois P. Ces parois sont disposées entre la matrice 28 de microlentilles et le détecteur 40, et sont destinées à séparer les voies les unes des autres.

En fait, on a là une transposition, au niveau d'une voie, du blindage périphérique dont il a été question dans la description de la figure 13B.

Au sujet de ces parois, on peut également se reporter à l'article de Jun Tanida et al. mentionné plus haut.

## Revendications

1. Dispositif d'imagerie infrarouge, comprenant :
- un support (62), comprenant un détecteur de rayonnement infrarouge (40) qui comporte une zone sensible au rayonnement infrarouge,
- au moins un dispositif optique (28, 88, 92), placé en regard du détecteur de rayonnement infrarouge, et
- un dispositif de blindage (32, c1, c2, cN-1, cN, C1, C2, 96, 98, 100, 102, 103, 121, 122) contre des rayonnements infrarouges parasites, à savoir un rayonnement parasite frontal, susceptible de pénétrer dans un espace compris entre le support et le dispositif optique, à travers ce dernier, et un rayonnement parasite latéral, susceptible de pénétrer latéralement dans cet espace,
**caractérisé en ce que** le dispositif de blindage comprend au moins un ensemble de blindage comportant N cordons continus (c1, c2, cN-1, cN, C1, C2, 98, 100, 102, 103), espacés les uns des autres, pourvus chacun d'un évent (e1, e2, eN-1, eN) et faits d'un matériau apte à atténuer significativement le rayonnement parasite latéral, et chacun des N cordons s'étend du support jusqu'au dispositif optique, où N est un nombre entier au moins égal à 2, dans lequel le cordon de rang 1 entoure au moins la zone sensible du détecteur de rayonnement infrarouge, le cordon de rang i entoure le cordon de rang i-1, pour i allant de 2 à N, et les N cordons, pourvus de leurs évents respectifs, forment au moins une chicane dans laquelle les évents de cordons de rangs successifs ne sont pas en regard l'un de l'autre.

2. Dispositif d'imagerie infrarouge selon la revendication 1, dans lequel, dans chaque ensemble de blindage, les évents respectifs (e1, e2, eN-1, eN) des cordons de rangs i et i+1, pour i allant de 1 à N-1, sont à 180° l'un de l'autre.

3. Dispositif d'imagerie infrarouge selon l'une quelconque des revendications 1 et 2, dans lequel la taille de chaque évent (e1, e2, eN-1, eN) est dans l'intervalle [1 µm ; 10 µm].

4. Dispositif d'imagerie infrarouge selon l'une quelconque des revendications 1 à 3, dans lequel N est au moins égal à 3.

5. Dispositif d'imagerie infrarouge selon l'une quelconque des revendications 1 à 4, dans lequel, dans chaque ensemble de blindage, l'espacement des cordons consécutifs (c1, c2, cN-1, CN, 98, 100, 102, 103) est dans l'intervalle [1 µm ; 10 µm].

6. Dispositif d'imagerie infrarouge selon l'une quelconque des revendications 1 à 5, dans lequel les cordons sont des cordons de brasure.

7. Dispositif d'imagerie infrarouge selon l'une quelconque des revendications 1 à 6, dans lequel le dispositif optique (28) comporte des première et deuxième faces opposées, la deuxième face est en regard du détecteur de rayonnement infrarouge (40), et le dispositif de blindage comprend en outre une couche (32) qui est formée sur la première face, est faite d'un matériau apte à atténuer le rayonnement parasite frontal, et comporte des ouvertures.

8. Dispositif d'imagerie infrarouge selon l'une quelconque des revendications 1 à 7, dans lequel ledit dispositif optique comprend sur ses côtés un matériau (d) apte à empêcher la transmission du rayonnement parasite latéral.

9. Dispositif d'imagerie infrarouge selon l'une quelconque des revendications 1 à 6, comportant M dispositifs optiques (88, 92), dans lequel le dispositif de blindage comprend M ensembles de blindage, où M est un nombre entier au moins égal à 2, chaque dispositif optique comporte des première et deuxième faces opposées, la deuxième face du dispositif optique de rang 1 est en regard du détecteur de rayonnement infrarouge (40), la deuxième face du dispositif optique de rang j est en regard de la première face du dispositif optique de rang j-1, l'ensemble de blindage de rang 1 s'étend du support jusqu'au dispositif optique de rang 1, et l'ensemble de blindage de rang j s'étend du dispositif optique de rang j-1 au dispositif optique de rang j, pour j allant de 2 à M, le dispositif de blindage comprend en outre une couche (96) qui est formée sur la face avant du dispositif optique de rang M, et cette couche est faite d'un matériau apte à atténuer le rayonnement parasite frontal et comporte des ouvertures.

10. Dispositif d'imagerie infrarouge selon l'une quelconque des revendications 1 à 9, dans lequel le support comprend en outre un substrat (62) et un circuit de lecture (38, 82) sur le substrat, le détecteur de rayonnement infrarouge (40) est hybridé au circuit de lecture par des billes de brasure (64), et le dispositif optique (28) le plus proche du substrat est relié à l'un des éléments choisis parmi le détecteur de rayonnement infrarouge, le circuit de lecture et le substrat, par l'intermédiaire d'un ensemble de blindage (c1, c2).

11. Dispositif d'imagerie infrarouge selon la revendication 10, dans lequel le support comprend en outre un réseau d'interconnexion (80) entre le substrat (62) et le circuit de lecture (82), et le dispositif optique (28) le plus proche du substrat est relié à l'un des éléments choisis parmi le détecteur de rayonnement infrarouge, le circuit de lecture, le substrat, et le réseau d'interconnexion, par l'intermédiaire d'un ensemble de blindage (C1, C2).

12. Dispositif d'imagerie infrarouge selon l'une quelconque des revendications 1 à 11, dans lequel au moins un dispositif optique comprend une matrice (28) de microlentilles définissant des voies de détection élémentaires, et le dispositif d'imagerie comprend en outre un ensemble (P) de parois faites d'un matériau apte à atténuer significativement les rayonnements parasites, disposées entre la matrice de microlentilles et le détecteur et destinées à séparer les voies élémentaires les unes des autres.

13. Procédé de fabrication du dispositif d'imagerie infrarouge selon l'une quelconque des revendications 1 à 12, dans lequel :
- on forme l'ensemble de blindage sur le support comprenant le détecteur de rayonnement infrarouge,
- on place le dispositif optique en regard du détecteur de rayonnement infrarouge, et
- on fixe le dispositif optique à l'ensemble de blindage.

14. Procédé selon la revendication 13, dans lequel :
- on assemble le détecteur de rayonnement infrarouge au support par la technique de puce retournée,
- on utilise des cordons de brasure pour former l'ensemble de blindage, et
- on fixe le dispositif optique aux cordons de brasure par la technique de puce retournée.

## Patentansprüche

1. Infrarotabbildungsvorrichtung, umfassend:
- einen Träger (62), umfassend einen Infrarotstrahlungsdetektor (40), der eine für Infrarotstrahlung empfindliche Zone umfasst,
- wenigstens eine optische Vorrichtung (28, 88, 92), die gegenüber dem Infrarotstrahlungsdetektor platziert ist, und
- eine Abschirmungsvorrichtung (32, c1, c2, cN-1, cN, C1, C2, 96, 98, 100, 102, 103, 121, 122) gegen parasitäre Infrarotstrahlen, nämliche eine parasitäre frontale Strahlung, die in einen Raum zwischen dem Träger und der optischen Vorrichtung durch diese letztgenannte hindurch eindringen kann, sowie eine laterale parasitäre Strahlung, die lateral in diesen Raum eindringen kann,
**dadurch gekennzeichnet, dass** die Abschirmungsvorrichtung wenigstens eine Abschirmungsgruppe umfasst, die N durchgehende Gürtel (c1, c2, cN-1, cN, C1, C2, 89, 100, 102, 103) umfasst, welche voneinander beabstandet sind, die jeweils mit einer Öffnung (e1, e2, eN-1, eN) versehen und aus einem Material hergestellt sind, das in der Lage ist, die laterale parasitäre Strahlung signifikant abzuschwächen, und wobei sich jeder der N Gürtel von dem Träger bis zur optischen Vorrichtung erstreckt, wobei N eine ganze Zahl größer oder gleich 2 ist, wobei der Gürtel mit Rang 1 wenigstens die empfindliche Zone des Infrarotstrahlungsdetektors umgibt, der Gürtel mit Rang i den Gürtel mit Rang i-1 umgibt, wobei i von 2 bis N läuft, und wobei die N Gürtel, mit ihren jeweiligen Öffnungen versehen, wenigstens eine Schikane bilden, wobei die Öffnungen von Gürteln mit aufeinander folgendem Rang sich nicht gegenüber liegen.

2. lnfrarotabbildungsvorrichtung nach Anspruch 1, wobei bei jeder Abschirmungsgruppe die jeweiligen Öffnungen (e1, e2, eN-1, eN) der Gürtel mit den Rängen i und i+1 sich zueinander unter 180° befinden, wobei i von 1 bis N-1 läuft.

3. Infrarotabbildungsvorrichtung nach einem der Ansprüche 1 und 2, wobei die Größe jeder Öffnung (e1, e2, eN-1, eN) in dem Intervall [1 µm; 10 µm] liegt.

4. Infrarotabbildungsvorrichtung nach einem der Ansprüche 1 bis 3, wobei N größer oder gleich 3 ist.

5. Infrarotabbildungsvorrichtung nach einem der Ansprüche 1 bis 4, wobei bei jeder Abschirmungsgruppe der Abstand aufeinanderfolgender Gürtel (c1, c2, cN-1, cN, 98, 100, 102, 103) in dem Intervall [1 µm; 10 µm] liegt.

6. Infrarotabbildungsvorrichtung nach einem der Ansprüche 1 bis 5, wobei die Gürtel Lötgürtel sind.

7. Infrarotabbildungsvorrichtung nach einem der Ansprüche 1 bis 6, wobei die optische Vorrichtung (28) eine erste und eine zweite entgegengesetzte Seiten umfasst, wobei die zweite Seite dem Infrarotstrahlungsdetektor (40) gegenüberliegt, und wobei die Abschirmungsvorrichtung ferner eine Schicht (32) umfasst, die an der ersten Seite gebildet ist, aus einem Material hergestellt ist, das in der Lage ist, die frontale parasitäre Strahlung abzuschwächen, und Öffnungen umfasst.

8. Infrarotabbildungsvorrichtung nach einem der Ansprüche 1 bis 7, wobei die optische Vorrichtung an ihren Seiten ein Material (d) umfasst, das in der Lage ist, die Transmission der lateralen parasitären Strahlung zu verhindern.

9. lnfrarotabbildungsvorrichtung nach einem der Ansprüche 1 bis 6, umfassend M optische Vorrichtungen (88, 92), wobei die Abschirmungsvorrichtung M Abschirmungsgruppen umfasst, wobei M eine ganze Zahl größer oder gleich 2 ist, wobei jede optische Vorrichtung eine erste und eine zweite entgegengesetzte Seiten umfasst, wobei die zweite Seite der optischen Vorrichtung mit Rang 1 dem Infrarotstrahlungsdetektor (40) gegenüberliegt, wobei die zweite Seite der optischen Vorrichtung mit Rang j der ersten Seite der optischen Vorrichtung mit Rang j-1 gegenüberliegt, wobei die Abschirmungsgruppe mit Rang 1 sich von dem Träger bis zur optischen Vorrichtung mit Rang 1 erstreckt, und wobei die Abschirmungsgruppe mit Rang j sich von der optischen Vorrichtung mit Rang j-1 bis zur optischen Vorrichtung mit Rang j erstreckt, wobei j von 2 bis M läuft, wobei die Abschirmungsvorrichtung ferner eine Schicht (96) umfasst, die an der Vorderfläche der optischen Vorrichtung mit Rang M gebildet ist, und wobei diese Schicht aus einem Material hergestellt ist, das in der Lage ist, die frontale parasitäre Strahlung abzuschwächen, und Öffnungen umfasst.

10. Infrarotabbildungsvorrichtung nach einem der Ansprüche 1 bis 9, wobei der Träger ferner ein Substrat (62) und eine Leseschaltung (38, 82) auf dem Substrat umfasst, wobei der Infrarotstrahlungsdetektor (40) mittels Lötkugeln (64) mit der Leseschaltung hybridisiert ist, und wobei die dem Substrat am nächsten befindliche optische Vorrichtung (28) mit Hilfe einer Abschirmungsgruppe (c1, c2) mit einem der Elemente verbunden ist ausgewählt aus dem Infrarotstrahlungsdetektor, der Leseschaltung und dem Substrat.

11. Infrarotabbildungsvorrichtung nach Anspruch 10, wobei der Träger ferner ein Verbindungsnetz (80) zwischen dem Substrat (62) und der Leseschaltung (82) umfasst, und die dem Substrat am nächsten befindliche optische Vorrichtung (28) mit Hilfe einer Abschirmungsgruppe (C1, C2) mit einem der Elemente verbunden ist ausgewählt aus dem Infrarotstrahlungsdetektor, der Leseschaltung, dem Substrat und dem Verbindungsnetz.

12. Infrarotabbildungsvorrichtung nach einem der Ansprüche 1 bis 11, wobei wenigstens eine optische Vorrichtung eine Matrix (28) aus Mikrolinsen umfasst, die elementare Detektionswege definieren, und wobei die Abbildungsvorrichtung ferner eine Gruppe (P) von Wänden umfasst, die aus einem Material hergestellt sind, das in der Lage ist, die parasitären Strahlen signifikant abzuschwächen, und die zwischen der Mikrolinsenmatrix und dem Detektor angeordnet und dazu bestimmt sind, die elementaren Wege voneinander zu separieren.

13. Verfahren zur Herstellung der Infrarotabbildungsvorrichtung nach einem der Ansprüche 1 bis 12, wobei:
- man die Abschirmungsgruppe auf dem Träger umfassend den Infrarotstrahlungsdetektor bildet,
- man die optische Vorrichtung gegenüber dem Infrarotstrahlungsdetektor platziert, und
- man die optische Vorrichtung an der Abschirmungsgruppe befestigt.

14. Verfahren nach Anspruch 13, wobei:
- man den Infrarotstrahlungsdetektor an dem Träger mittels der Flipchiptechnik anbringt,
- man Lötgürtel verwendet, um die Abschirmungsgruppe zu bilden, und
- man die optische Vorrichtung mittels der Flipchiptechnik an den Lötgürteln befestigt.

## Claims

1. Infrared imagery device comprising:
- a support (62), comprising an infrared radiation detector (40) that comprises a zone sensitive to infrared radiation,
- at least one optical device (28, 88, 92), placed facing the infrared radiation detector, and
- a shield device (32, c1, c2, cN-1, cN, C1, C2, 96, 98, 100, 102, 103, 121, 122) against parasite infrared radiation, namely frontal parasite radiation capable of penetrating into a space between the support and the optical device, through this optical device, and lateral parasite radiation that can penetrate laterally into this space,
**characterised in that** the shield device comprises at least a shield assembly comprising N continuous beads (c1, c2, cN-1, cN, C1, C2, 98, 100, 102, 103), spaced from each other, each provided with a vent (e1, e2, eN-1, eN) and made of a material that can significantly attenuate lateral parasite radiation, and each of the N beads extends from the support as far as the optical device, in which N is an integer number equal to at least 2, in which the rank 1 bead surrounds at least the sensitive zone of the infrared radiation detector, the rank i bead surrounds the rank i-1 bead, where i varies from 2 to N, and the N beads provided with their corresponding vents form at least one baffle wherein the sequential rank bead vents are not facing each other.

2. Infrared imagery device according to claim 1, in which, in each shield assembly, the vents (e1, e2, eN-1, eN) for rank i and i+1 1 beads respectively, where i varies from 1 to N-1, are at 180° from each other.

3. Infrared imagery device according to any one of claims 1 and 2, in which the size of each vent (e1, e2, eN-1, eN) is within the interval [1 µm; 10 µm].

4. Infrared imagery device according to any one of claims 1 to 3, in which N is equal to at least 3.

5. Infrared imagery device according to any one of claims 1 to 4, in which the spacing between consecutive beads (c1, c2, cN-1, CN, 98, 100, 102, 103) in each shield assembly is within the interval [1 µm; 10 µm].

6. Infrared imagery device according to any one of claims 1 to 5, in which the beads are solder beads.

7. Infrared imagery device according to any one of claims 1 to 6, in which the optical device (28) comprises first and second opposite faces, the second face is facing the infrared radiation detector (40), and the shield device also comprises a layer (32) formed on the first face, made of a material capable of attenuating frontal parasite radiation, and comprises apertures.

8. Infrared imagery device according to any one of claims 1 to 7, in which said optical device comprises a material (d) on its sides capable of preventing transmission of lateral parasite radiation.

9. Infrared imagery device according to any one of claims 1 to 6, comprising M optical devices (88, 92), in which the shield device comprises M shield assemblies, where M is an integer number equal to at least 2, each optical device comprises first and second opposite faces, the second face of the rank 1 optical device faces the infrared radiation detector (40), the second face of the rank j optical device is facing the first face of the rank j-1 optical device, the rank 1 shield assembly extends from the support as far as the rank 1 optical device, and the rank j shield assembly extends from the rank j-1 optical device to the rank j optical device, where j varies from 2 to M, the shield device also comprises a layer (96) formed on the front face of the rank M optical device, and this layer is made of a material capable of attenuating frontal parasite radiation and comprises apertures.

10. Infrared imagery device according to any one of claims 1 to 9, in which the support also comprises a substrate (62) and a read circuit (38, 82) on the substrate, the infrared radiation detector (40) is hybridised to the read circuit by solder balls (64), and the optical device (28) closest to the substrate is connected to one of the elements chosen from among the infrared radiation detector, the read circuit and the substrate through a shield assembly (c1, c2).

11. Infrared imagery device according to claim 10, in which the support also comprises an interconnection network (80) between the substrate (62) and the read circuit (82), and the optical device (28) closest to the substrate is connected to one of the elements chosen among the infrared radiation detector, the read circuit, the substrate and the interconnection network through a shield assembly (C1, C2).

12. Infrared imagery device according to any one of claims 1 to 11, in which at least one optical device comprises a microlens matrix (28) defining elementary detection channels, and the imagery device also comprises a set of walls (P) made of a material capable of significantly attenuating parasite radiation, placed between the microlens matrix and the detector and that will separate the elementary channels from each other.

13. Method of manufacturing the infrared imagery device according to any one of claims 1 to 12, in which:
- the shield assembly is made on the support comprising the infrared radiation detector,
- the optical device is placed facing the infrared radiation detector, and
- the optical device is fixed to the shield assembly.

14. Method according to claim 13, in which:
- the infrared radiation detector is assembled to the support using the flip chip technique,
- solder beads are used to form the shield assembly, and
- the optical device is fixed to the solder beads using the flip chip technique.
